# EUROPÄISCHE PATENTSCHRIFT

(11) **EP 3 764 754 B1**
(45) Veröffentlichungstag und Bekanntmachung des Hinweises auf die Patenterteilung: **08.11.2023**
(21) Anmeldenummer: 20185321.5
(22) Anmeldetag: 10.07.2020
(51) Int. Cl.: H05K 1/05, H01L 33/00, H01L 33/64, H05K 1/18

(54) **VERFAHREN ZUM HERSTELLEN EINER SCHALTUNGSTRÄGERPLATTE UND SCHALTUNGSTRÄGERPLATTE**
CIRCUIT CARRIER PLATE AND METHOD FOR PRODUCING SAME
PROCÉDÉ DE FABRICATION D'UNE PLAQUETTE DE SUPPORT DE CIRCUIT ET PLAQUETTE DE SUPPORT DE CIRCUIT

(30) Priorität: 12.07.2019 DE 102019118966
(43) Veröffentlichungstag der Anmeldung: 13.01.2021
(73) Patentinhaber: Marelli Automotive Lighting Reutlingen (Germany) GmbH, 72762 Reutlingen (DE)
(72) Erfinder: Schöning, Michael, 37154 Northeim (DE)
(74) Vertreter: DREISS Patentanwälte PartG mbB

(56) Entgegenhaltungen:
- JP-A- 2019 086 778
- KR-A- 20120 092 685
- US-A1- 2005 073 846
- US-A1- 2006 137 517
- US-A1- 2010 123 164
- US-A1- 2012 267 149
- US-A1- 2015 107 882

## Beschreibung

Die Offenbarung betrifft ein Verfahren zum Herstellen einer Schaltungsträgerplatte.

Die Offenbarung betrifft ferner eine Schaltungsträgerplatte.

Aus der DE 10 2006 034 425 A1 ist ein Leistungs-LED-Modul bekannt, das einen zur Kühlung der LED vorgesehenen Kühlkörper aus Metall aufweist. US 2015/107882 A1 beschreibt eine Schaltungsträgerplatte mit einer Basis und einer elektrisch leitenden Schicht, wobei ein keramisches Element in einer Öffnung der Basis angeordnet und mit dieser verlötet wird. KR 20120092685 A beschreibt ein Herstellungsverfahren für eine Schaltungsträgerplatte mit Metallbasis. US 2005/073846 A1 und US 2010/123164 A1 beschreiben jeweils eine Licht emittierende Vorrichtung und ein Herstellungsverfahren hierfür. US 2012/267149 A1 beschreibt ein Substrat für ein Leistungsmodul und ein Herstellungsverfahren hierfür. JP 2019/086778 A beschreibt eine optische Wellenlängen-Umwandlungskomponente, eine Licht emittierende Vorrichtung, und ein Herstellungsverfahren für die optische Wellenlängen-Umwandlungskomponente. US 2006/137517 A1 beschreibt eine keramische Panzerung und ein Herstellungsverfahren hierfür.

Eine Ausführungsform der Erfindung bezieht sich auf ein Verfahren zum Herstellen einer Schaltungsträgerplatte gemäß Anspruch 1. Dadurch ist vorteilhaft eine Schaltungsträgerplatte mit Einsatz bereitgestellt, mit der vielfältige elektrische Schaltungen realisierbar sind. Das Verfahren ist gegenüber konventionellen Ansätzen, die auf einem Einbringen von Einsätzen in Faserverbundwerkstoffe aufweisende Trägerplatten beruhen, vergleichsweise einfach und kostengünstig. Zudem kann sich bei weiteren bevorzugten Ausführungsformen durch das Einpressen ein guter thermischer Kontakt zwischen Seitenwänden des Einsatzes und der Trägerplatte ergeben, wodurch das Ableiten bzw. Wegführen von Wärme, also ein Wärmetransport, verbessert wird. Zusätzlich zu einem Wärmetransport bzw. einer Wärmeleitung entlang einer Dickenkoordinate des Einsatzes, also z.B. senkrecht zu einer Oberfläche der Trägerplatte bzw. des Einsatzes, ist bei weiteren bevorzugten Ausführungsformen durch das Einpressen auch ein verbesserter Wärmetransport in einer zu der Oberfläche der Trägerplatte parallelen virtuellen Ebene, die innerhalb der Trägerplatte liegt, gegeben, der durch die vergleichsweise große Mantelfläche des Einsatzes und den direkten Wärmeübergang von dem Einsatz zu der Trägerplatte bedingt wird.

Bei weiteren bevorzugten Ausführungsformen kann auch mehr als ein Einsatz, insbesondere auch unterschiedlich geformte, Einsätze in dieselbe Trägerplatte eingepresst werden. Bei weiteren bevorzugten Ausführungsformen können ein oder mehrere elektrische und/oder elektronische Bauelemente oder sonstige Bauelement bzw. Komponenten auf wenigstens einer Oberfläche des Einsatzes bzw. der Trägerplatte bzw. einer gemäß weiteren bevorzugten Ausführungsformen ggf. darauf angeordneten Schicht vorgesehen werden, wodurch weitere Freiheitsgrade zur Ausbildung von elektronischen Schaltungen und zur Entwärmung von Bauteilen angegeben sind.

Beispielhaft kann der Einsatz zumindest teilweise in die metallische Trägerplatte eingepresst werden. Hierbei kann eine Einpresstiefe, um die der Einsatz in die metallische Trägerplatte eingepresst wird, z.B. bezogen auf eine Oberfläche der Trägerplatte, kleiner sein als die Dicke des Einsatzes, d.h. der Einsatz kann bei diesen Ausführungsformen ggf. um einen nichtverschwindenden ersten Abstand über die Oberfläche der Trägerplatte, in die er eingepresst worden ist, herausstehen. Dies kann beispielsweise vorteilhaft sein, um eine elektrische Isolation zwischen ersten Komponenten zu bewirken, die auf einer an den Einsatz angrenzenden Oberfläche der Trägerplatte bzw. einer darauf angeordneten Schicht angeordnet sind, und zweiten Komponenten, die z.B. auf einer aus der Trägerplatte herausragenden Oberfläche des teilweise eingepressten Einsatzes vorgesehen sind. Dabei kann ein Isolationsabstand wenigstens dem ersten Abstand entsprechen. Bei weiteren bevorzugten Ausführungsformen ist vorgesehen, dass der Einsatz vollständig, insbesondere oberflächenbündig, in die metallische Trägerplatte eingepresst wird. Bei diesen Ausführungsformen liegt eine Oberfläche des Einsatzes in derselben virtuellen Ebene wie die entsprechende Oberfläche der Trägerplatte (ggf. zuzüglich einer optionalen Beschichtung der Trägerplatte), in die der Einsatz eingepresst ist. Bei diesen Ausführungsformen ergibt sich aufgrund der großen Kontaktfläche zwischen den Seitenwänden des Einsatzes und dem sie umgebenden Material der Trägerplatte ein besonders guter Wärmetransport entlang einer in der Trägerplatte liegenden Ebene.

Es ist vorgesehen, dass die metallische Trägerplatte während des Einpressens des Einsatzes zumindest bereichsweise plastisch verformt wird, wobei Material der Trägerplatte zumindest bereichsweise durch das Material des Einsatzes verdrängt wird. Dadurch kann der Einsatz besonders sicher in das Material der Trägerplatte eingebettet werden. Bei weiteren bevorzugten Ausführungsformen ist vorgesehen, dass auf wenigstens einer Oberfläche der metallischen Trägerplatte zumindest bereichsweise eine dielektrische Schicht angeordnet ist, wobei auf einer ersten Oberfläche der dielektrischen Schicht zumindest bereichsweise eine metallische Funktionsschicht angeordnet ist, wobei das Verfahren weiter aufweist: zumindest bereichsweises Entfernen (z.B. mittels Fräsen) wenigstens einer der beiden Schichten, vorzugsweise beider Schichten, insbesondere in einem Oberflächenbereich der Trägerplatte, in dem der Einsatz eingepresst werden soll. Dadurch kann der Einsatz direkt in das Material der Trägerplatte eingepresst werden, und die genannte(n) Schicht(en) können vor dem Einpressen des Einsatzes kontrolliert zumindest bereichsweise entfernt werden.

Bei weiteren bevorzugten Ausführungsformen kann die metallische Funktionsschicht beispielsweise Leiterbahnstrukturen und/oder Kontaktierungsflächen zur Anbringung von und/oder elektrische leitfähigen Verbindung mit elektrischen und/oder elektronischen Bauelementen aufweisen.

Bei weiteren bevorzugten Ausführungsformen kann auch wenigstens eine Oberfläche des Einsatzes zumindest bereichsweise eine metallische Funktionsschicht aufweisen, beispielsweise zur Vorsehung von Leiterbahnstrukturen und/oder Kontaktierungsflächen zur Anbringung von und/oder elektrische leitfähigen Verbindung mit elektrischen und/oder elektronischen Bauelementen.

Bei weiteren bevorzugten Ausführungsformen ist vorgesehen, dass die metallische Trägerplatte profiliert ist, wobei das Einpressen des Einsatzes in einem Oberflächenbereich der Trägerplatte erfolgt, in dem eine lokale Dicke der Trägerplatte geringer ist als eine maximale Dicke der Trägerplatte. Beispielsweise kann die Trägerplatte eine im wesentlichen quaderförmige Grundform aufweisen, mit einer Breite und einer Länge, die jeweils größer, insbesondere wesentlich (mehr als um einen Faktor zehn) größer, ist als eine Höhe bzw. Dicke der Trägerplatte. Bei weiteren Ausführungsformen kann die Profilierung der Trägerplatte so ausgebildet sein, dass sich die Dicke der Trägerplatte entlang wenigstens ihrer Breitenkoordinate und/oder ihrer Längenkoordinate ändert, insbesondere periodisch ändert. Bei weiteren Ausführungsformen kann die gesamte Trägerplatte profiliert sein, und bei noch weiteren Ausführungsformen ist es auch möglich, dass nur ein oder mehrere vorgebbare Teilbereiche der Trägerplatte profiliert sind. Insbesondere kann bei weiteren bevorzugten Ausführungsformen eine Rückseite (bezogen auf das Einpressen des Einsatzes) der Trägerplatte profiliert sein bzw. wenigstens ein Teilbereich der Rückseite.

Bei weiteren bevorzugten Ausführungsformen ändert sich die Dicke der Trägerplatte z.B. entlang der Breitenkoordinate der Trägerplatte, z.B. sinusförmig, während die Dicke der Trägerplatte entlang der zu der Breitenkoordinate orthogonalen Längenkoordinate zumindest in etwa konstant bleibt. Eine Trägerplatte mit einem derartigen Profil kann bei weiteren bevorzugten Ausführungsformen beispielhaft mittels Strangpressen erhalten werden.

Eine weitere Ausführungsform der Erfindung bezieht sich auf ein Verfahren zum Herstellen einer Schaltungsträgerplatte gemäß Anspruch 5. Das zumindest bereichsweises Entfernen von Material der metallischen Trägerplatte kann z.B. mittels Fräsen erfolgen, insbesondere in einem bzw. dem Oberflächenbereich der Trägerplatte, in dem der Einsatz eingepresst werden soll. Dadurch kann eine Menge von Material der Trägerplatte, die bei dem Einpressen des Einsatzes, z.B. um eine vorgebbare Einpresstiefe, zu verdrängen ist, vermindert werden.

Bei weiteren bevorzugten Ausführungsformen kann das zumindest bereichsweise Entfernen von Material der metallischen Trägerplatte z.B. in einem Bereich vorgenommen werden, der i.w. einer Querschnittsform des Einsatzes entspricht oder zumindest geringfügig größer ist. Dadurch kann eine effiziente Vorpositionierung des Einsatzes vor dem Einpressen erfolgen, z.B. indem der Einsatz in den Bereich eingesetzt bzw. eingelegt wird, in dem zuvor das Material der metallischen Trägerplatte entfernt worden ist. Zudem kann bei diesen Ausführungsformen vermieden werden, eine ggf. vorhandene elektrisch leitfähige Beschichtung des Einsatzes in Kontakt mit elektrisch leitfähigen Strukturen der Trägerplatte zu bringen.

Es ist vorgesehen, dass das zumindest bereichsweise Entfernen von Material der metallischen Trägerplatte zum Anfertigen einer Tasche (z.B. zumindest i.w. quaderförmige Öffnung bzw. Ausnehmung) in der Trägerplatte zur Aufnahme des Einsatzes dient. Bei weiteren beispielhaften Ausführungsformen ist eine Tiefe der Tasche bevorzugt gleich oder größer einer Dicke des Einsatzes ist, insbesondere gleich oder größer einer Dicke eines Grundkörpers des Einsatzes.

Es ist vorgesehen, dass das Einpressen aufweist: Einlegen und/oder Einpressen des Einsatzes in die Tasche, plastisches Verformen wenigstens eines Randbereichs der Tasche so, dass der (insbesondere in die Tasche eingelegte bzw. eingepresste) Einsatz, insbesondere der Grundkörper des Einsatzes, formschlüssig durch wenigstens einen plastisch verformten Randbereich in der Tasche gehalten ist.

Bei weiteren bevorzugten Ausführungsformen ist vorgesehen, dass die Tasche eine mehrere Kanten aufweisende polygonale (z.B. zumindest i.w. rechteckförmige) Öffnung im Bereich der Oberfläche der Trägerplatte aufweist, wobei das plastische Verformen des wenigstens eines Randbereichs der Tasche ein plastisches Verformen von mehreren Randbereichen der Tasche aufweist, wobei die mehreren Randbereiche wenigstens zwei bevorzugt nicht nebeneinander liegenden Kanten der polygonalen Öffnung entsprechen (z.B. einander gegenüberliegenden Kanten der zumindest i.w. rechteckförmigen Öffnung).

Eine weitere Ausführungsform der Erfindung bezieht sich auf eine Schaltungsträgerplatte, erhältlich durch ein Verfahren gemäß einem der Ansprüche 1-7. Bei weiteren bevorzugten Ausführungsformen können auch mehrere gleichartige oder verschiedenartige Einsätze in die metallische Trägerplatte eingepresst sein. Bei weiteren bevorzugten Ausführungsformen ist vorgesehen, dass der Einsatz kraftschlüssig und/oder formschlüssig in der Trägerplatte gehalten ist.

Ein Kraftschluss zwischen dem Einsatz und der Trägerplatte kann bei weiteren bevorzugten Ausführungsformen beispielsweise dadurch erzielt werden, dass der Einsatz geringfügig größer ist als eine ihn aufnehmende Öffnung der Trägerplatte. Dadurch wird bei dem Einpressen des Einsatzes Material der Trägerplatte zumindest bereichsweise elastisch verformt und übt somit zumindest bereichsweise eine Haltekraft auf den eingepressten Einsatz aus.

Bei weiteren bevorzugten Ausführungsformen kann sich auch nach dem Einpressen unter zumindest bereichsweiser plastischer Verformung der Trägerplatte ein Kraftschluss zwischen der Trägerplatte und dem Einsatz ergeben.

Ein Formschluss zwischen dem Einsatz und der Trägerplatte kann bei weiteren bevorzugten Ausführungsformen beispielsweise dadurch erzielt werden, dass der Einsatz kleiner ist als eine ihn aufnehmende Öffnung der Trägerplatte, so dass er i.w. kräftefrei bzw. schwerkraftunterstützt in die Öffnung eingelegt werden kann. Sodann kann wenigstens ein Randbereich der Öffnung plastisch verformt werden, um den genannten Formschluss herzustellen, wodurch z.B. ein Herausfallen des Einsatzes aus der Öffnung verhindert wird bzw. eine Bewegung des Einsatzes relativ zu der Trägerplatte.

Bei weiteren bevorzugten Ausführungsformen ist vorgesehen, dass der Einsatz zumindest teilweise in die metallische Trägerplatte eingepresst ist, also z.B. mit einem Bruchteil seiner Dicke noch aus der Trägerplatte herausragt.

Bei weiteren bevorzugten Ausführungsformen ist vorgesehen, dass der Einsatz vollständig, insbesondere oberflächenbündig, in die metallische Trägerplatte eingepresst ist. Dadurch ergibt sich insbesondere auch in dem Bereich der Trägerplatte, der den Einsatz aufweist, eine i.w. ebene, durchgehende Oberfläche, auf der gemäß weiteren bevorzugten Ausführungsformen weitere Bauteile und/oder Beschichtungen aufbringbar sind.

Bei weiteren bevorzugten Ausführungsformen ist vorgesehen, dass die metallische Trägerplatte profiliert ist, wobei der Einsatz in einem Oberflächenbereich der Trägerplatte eingepresst ist, in dem eine lokale Dicke der Trägerplatte (insbesondere vor dem Einpressen) geringer ist als eine maximale Dicke der Trägerplatte.

Bei weiteren bevorzugten Ausführungsformen ist vorgesehen, dass die metallische Trägerplatte ein Nichteisenmetall, insbesondere Aluminium, aufweist.

Bei weiteren bevorzugten Ausführungsformen weist die Trägerplatte z.B. den folgenden Werkstoff auf, oder ein vergleichbares, insbesondere ebenfalls vergleichsweise gut verformbares, Material:
Al99,5 (3.0255 (DIN 1725-1)) Europäische Norm (EN) AW 1050,

Diese Werkstoffe ermöglichen ein besonders effizientes Einpressen wenigstens eines Einsatzes und eine sichere Halterung des wenigstens einen eingepressten Einsatzes.

Weitere Merkmale, Anwendungsmöglichkeiten und Vorteile weiterer bevorzugter Ausführungsformen ergeben sich aus der nachfolgenden Beschreibung und den Figuren der Zeichnung.

In der Zeichnung zeigt:
- Fig. 1A: schematisch eine Seitenansicht einer Schaltungsträgerplatte gemäß bevorzugten Ausführungsformen in einem ersten Zustand,
- Fig. 1B: schematisch eine Seitenansicht der Schaltungsträgerplatte gemäß Fig. 1A in einem zweiten Zustand,
- Fig. 2: schematisch eine Seitenansicht einer Schaltungsträgerplatte gemäß weiteren bevorzugten Ausführungsformen in teilweisem Querschnitt,
- Fig. 3: schematisch eine Seitenansicht einer Schaltungsträgerplatte gemäß weiteren bevorzugten Ausführungsformen in teilweisem Querschnitt,
- Fig. 4: schematisch eine Seitenansicht einer Schaltungsträgerplatte gemäß weiteren bevorzugten Ausführungsformen in teilweisem Querschnitt,
- Fig. 5: schematisch eine Draufsicht auf eine Schaltungsträgerplatte gemäß weiteren bevorzugten Ausführungsformen,
- Fig. 6A: schematisch eine Seitenansicht einer Schaltungsträgerplatte gemäß weiteren bevorzugten Ausführungsformen in teilweisem Querschnitt in einem ersten Zustand,
- Fig. 6B: schematisch eine Seitenansicht der Schaltungsträgerplatte gemäß Fig. 6A in teilweisem Querschnitt in einem zweiten Zustand,
- Fig. 7A: schematisch eine Seitenansicht einer Schaltungsträgerplatte gemäß weiteren bevorzugten Ausführungsformen in teilweisem Querschnitt in einem ersten Zustand,
- Fig. 7B: schematisch eine Seitenansicht der Schaltungsträgerplatte gemäß Fig. 7A in teilweisem Querschnitt in einem zweiten Zustand,
- Fig. 8: schematisch eine perspektivische Ansicht eines Einsatzes für eine Schaltungsträgerplatte gemäß weiteren bevorzugten Ausführungsformen,
- Fig. 9A: ein vereinfachtes Flussdiagramm eines Verfahrens gemäß weiteren bevorzugten Ausführungsformen,
- Fig. 9B: ein vereinfachtes Flussdiagramm eines Verfahrens gemäß weiteren bevorzugten Ausführungsformen,
- Fig. 9C: ein vereinfachtes Flussdiagramm eines Verfahrens gemäß weiteren bevorzugten Ausführungsformen,
- Fig. 10: schematisch eine perspektivische Ansicht einer Schaltungsträgerplatte gemäß weiteren bevorzugten Ausführungsformen, und
- Fig. 11: schematisch eine perspektivische Ansicht einer Schaltungsträgerplatte gemäß eines Beispiels, das nicht zur Erfindung gehört.

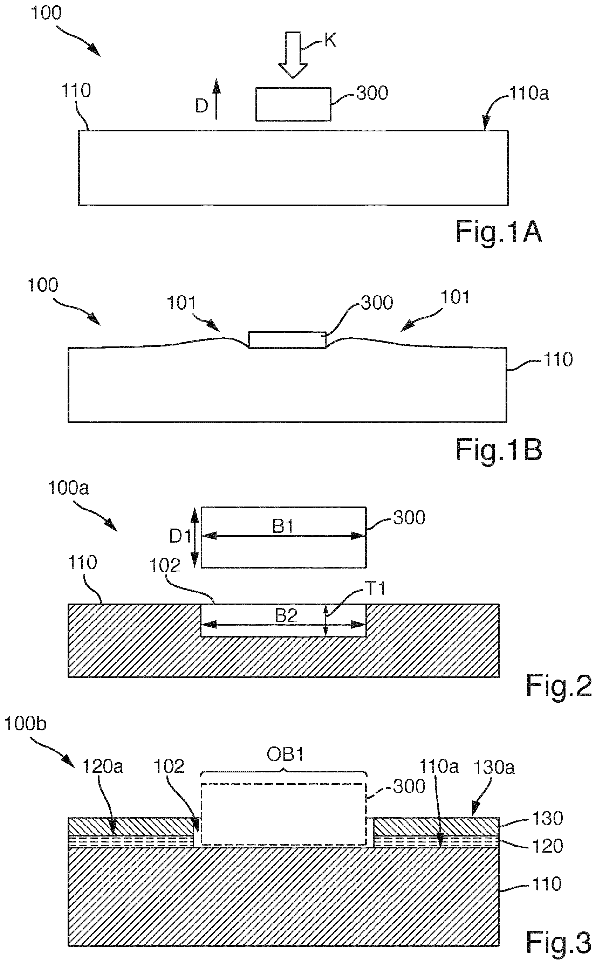

Figur 1A zeigt schematisch eine Seitenansicht einer Schaltungsträgerplatte 100 während der Herstellung gemäß einer Ausführungsform der Erfindung.

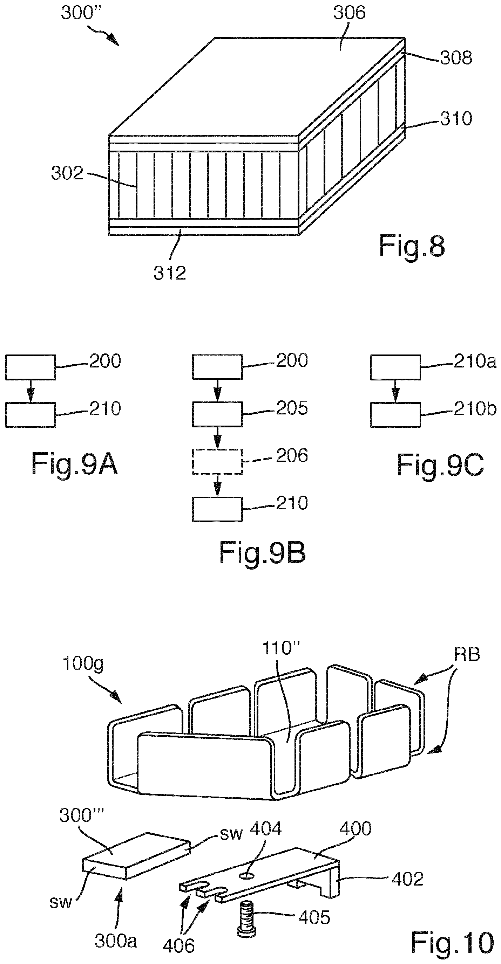

Die Schaltungsträgerplatte 100 weist eine metallische Trägerplatte 110 auf. Ebenfalls in Fig. 1A abgebildet ist ein wenigstens ein Keramikmaterial aufweisender Einsatz 300, der zumindest teilweise in die Trägerplatte 110 eingepresst wird. Dadurch wird ein zweiter Zustand der Schaltungsträgerplatte 100 erhalten, wie er vorliegend beispielhaft durch Figur 1B veranschaulicht ist. Figur 9A zeigt hierzu ein vereinfachtes Flussdiagramm gemäß

einer Ausführungsform der Erfindung. In Schritt 200 wird die metallische Trägerplatte 110 bereitgestellt, und in Schritt 210 wird der Einsatz 300 (Fig. 1A) in die metallische Trägerplatte 110 eingepresst, wodurch z.B. der Zustand gemäß Fig. 1B erhalten wird. Dadurch ist vorteilhaft eine Schaltungsträgerplatte 100 mit Einsatz 300 bereitgestellt, mit der vielfältige elektrische Schaltungen realisierbar sind. Das Verfahren ist gegenüber konventionellen Ansätzen, die auf einem Einbringen von Einsätzen in Faserverbundwerkstoffe aufweisende Trägerplatten beruhen, vergleichsweise einfach. Zudem kann sich bei weiteren bevorzugten Ausführungsformen durch das Einpressen 210 (Fig. 9A) ein guter thermischer Kontakt zwischen Seitenwänden des Einsatzes 300 und der Trägerplatte 110 ergeben, wodurch ein Wärmetransport verbessert wird.

Bei weiteren bevorzugten Ausführungsformen ist vorgesehen, dass der Einsatz 300 zumindest teilweise in die metallische Trägerplatte 110 eingepresst wird bzw. ist, also z.B. mit einem Bruchteil seiner Dicke noch aus der Trägerplatte 110 herausragt. Dieser Zustand ist in Fig. 1B gezeigt.

Bei dieser Ausführungsform der Erfindung ist vorgesehen, dass die metallische Trägerplatte 110 während des Einpressens 210 (Fig. 9A) des Einsatzes 300 (Fig. 1A, 1B) zumindest bereichsweise plastisch verformt wird, wobei Material der Trägerplatte 110 zumindest bereichsweise durch das Material des Einsatzes 300 verdrängt wird. Dadurch kann der Einsatz 300 besonders sicher in das Material der Trägerplatte 110 eingebettet werden. Die genannte plastische Verformung kann beispielsweise dann eintreten, wenn der Einsatz mit einer hinreichend großen Kraft K (Fig. 1A) in die Trägerplatte 110 hineingepresst wird. Hierbei ergibt sich eine Kraftwirkung von einer nicht abgebildeten externen Vorrichtung, z.B. einem Presswerkzeug, das die in Fig. 1A vertikal nach unten weisende Kraft K auf den Einsatz 300 ausübt, der wiederum eine entsprechende Kraftwirkung auf das Material der Trägerplatte 110 ausübt. Das Material der Trägerplatte 110 verformt sich hierbei plastisch, wodurch z.B. Materialanhäufungen 101 entstehen können. Auch nach Entfernen der externen Kraft K verbleibt der Einsatz 300 in seinem zumindest teilweise in die Trägerplatte 110 eingepressten Zustand, vgl. Fig. 1B. Figur 2 zeigt schematisch eine Seitenansicht einer Schaltungsträgerplatte 100a gemäß weiteren bevorzugten Ausführungsformen in teilweisem Querschnitt. Im Unterschied zu der Konfiguration 100 gemäß Figur 1A weist die Trägerplatte 110 der Konfiguration 100a nach Fig. 2 einen Bereich 102 ("Tasche") auf, aus dem vor dem Einbringen des Einsatzes 300 in die Trägerplatte 110 Material der metallischen Trägerplatte 110 entfernt worden ist. Das Entfernen kann z.B. in einem Bereich vorgenommen werden, der i.w. einer Querschnittsform des Einsatzes 300 entspricht oder zumindest geringfügig größer ist. Dadurch kann eine effiziente Vorpositionierung des Einsatzes 300 vor dem Einpressen 210 (Fig. 9A) erfolgen, z.B. indem der Einsatz 300 in den Bereich 102 eingesetzt bzw. eingelegt wird, in dem zuvor das Material der metallischen Trägerplatte entfernt worden ist.

Bei weiteren bevorzugten Ausführungsformen entspricht eine Breite B2 der Tasche 102 zumindest in etwa einer Breite B1 des Einsatzes 300 (Vergleichbares kann z.B. auch für eine senkrecht zur Zeichenebene der Fig. 2 betrachtete Länge der Elemente 102, 300 gelten), so dass der Einsatz 300 mittels einer vergleichsweise geringen Kraft K (Fig. 1A) in die Tasche 102 eingefügt bzw. eingepresst werden kann.

Bei weiteren bevorzugten Ausführungsformen ist eine Tiefe T1 der Tasche kleiner als eine Dicke D1 des Einsatzes 300, so dass der Einsatz 300 nach dem Einpressen 210 (Fig. 9A) um ein entsprechendes Maß D1-T1 über die Oberfläche 110a (Fig. 1A) des Trägerelements 110 herausragt, sofern er nicht - was gemäß weiteren bevorzugten Ausführungsformen möglich ist - weiter als die Tiefe T1 in das Trägerelement 110 hineingepresst wird, wodurch die bereits genannte plastische Verformung des Trägerelements 110 eintritt. Weiter bevorzugt ist die Dicke D1 des Einsatzes 300 kleiner als die Dicke des Trägerelements 110.

Bei weiteren bevorzugten Ausführungsformen, vgl. die Seitenansicht der Schaltungsträgerplatte 100b aus Fig. 3, ist vorgesehen, dass auf wenigstens einer Oberfläche 110a der metallischen Trägerplatte 110 zumindest bereichsweise eine dielektrische Schicht 120 angeordnet ist, wobei auf einer ersten Oberfläche 120a der dielektrischen Schicht 120 zumindest bereichsweise eine metallische Funktionsschicht 130 angeordnet ist.

Bei weiteren bevorzugten Ausführungsformen kann die metallische Funktionsschicht 130 beispielsweise Leiterbahnstrukturen und/oder Kontaktierungsflächen zur Anbringung von und/oder elektrische leitfähigen Verbindung mit elektrischen und/oder elektronischen Bauelementen (nicht gezeigt) aufweisen, so dass auf einer Oberfläche 130a der Funktionsschicht 130 Bauelemente (nicht gezeigt) angeordnet und/oder elektrisch verbunden werden können.

Bei weiteren bevorzugten Ausführungsformen kann auch wenigstens eine Oberfläche des Einsatzes 300 zumindest bereichsweise eine metallische Funktionsschicht (nicht in Fig. 3 gezeigt) aufweisen, beispielsweise zur Vorsehung von Leiterbahnstrukturen und/oder Kontaktierungsflächen zur Anbringung von und/oder elektrische leitfähigen Verbindung mit elektrischen und/oder elektronischen Bauelementen.

Die Konfiguration nach Fig. 3 kann bei weiteren bevorzugten Ausführungsformen auch als Isolated Metal Substrate, IMS, bezeichnet werden. Bei weiteren bevorzugten Ausführungsformen können bei einem solchen IMS auch die folgenden Schritte ausgeführt werden: a) Einpressen (des Einsatzes), b) Strukturieren der vorstehend erwähnte metallischen Funktionsschicht, c) (optional) Aufkupfern, insbesondere zum Verbinden des Einsatzes mit der Trägerplatte.

Auch bei Ausführungsformen wie z.B. in Fig. 3 gezeigt, bei denen die Schaltungsträgerplatte 100b eine dielektrische Schicht 120 mit metallischer Funktionsschicht 130 aufweist, kann bei weiteren bevorzugten Ausführungsformen ein Einsatz 300 in die Trägerplatte 110 eingepresst werden. Bevorzugt wird hierzu vor dem Einpressen eine Tasche 102 gebildet, z.B. durch zumindest bereichsweises Entfernen wenigstens einer der beiden Schichten 120, 130, vorzugsweise beider Schichten 120, 130, insbesondere in einem Oberflächenbereich OB1 der Trägerplatte 110, in dem der Einsatz 300 eingepresst werden soll. Dadurch kann der Einsatz 300 direkt in das Material der Trägerplatte 110 eingepresst werden.

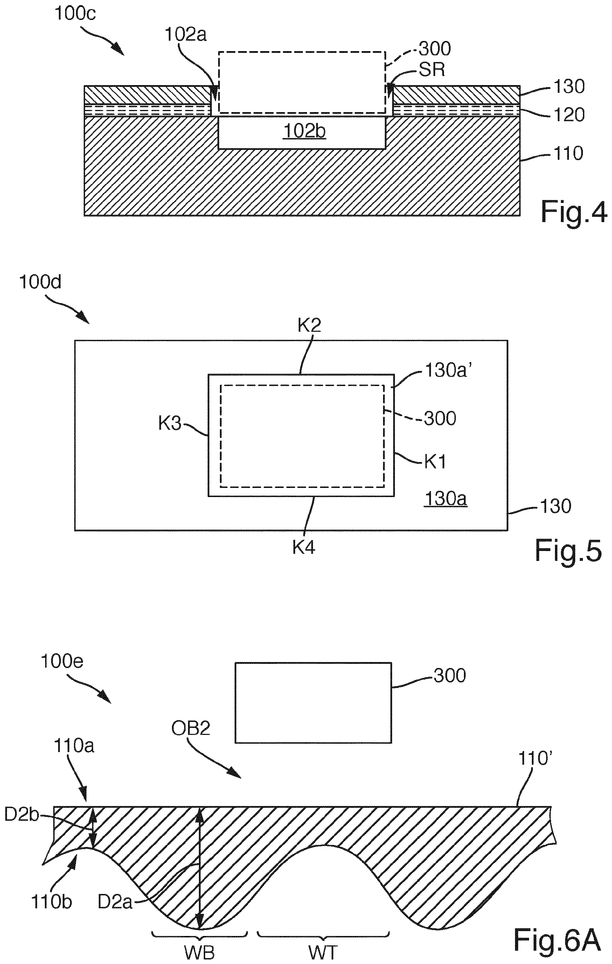

Figur 9B zeigt hierzu ein vereinfachtes Flussdiagramm gemäß weiteren bevorzugten Ausführungsformen. In Schritt 200 wird die metallische Trägerplatte 110 (Fig. 3) bereitgestellt, in Schritt 205 (Fig. 9B) wird wenigstens eine der beiden (vorzugsweise beide) Schichten 120, 130 zumindest bereichsweise entfernt, und in Schritt 210 wird der Einsatz 300 in die metallische Trägerplatte 110 eingepresst. Optional kann nach Schritt 205 auch ein weiterer Schritt 206 vorgesehen sein, bei dem zumindest bereichsweise (auch) Material der Trägerplatte 110 entfernt wird. Dies ist nachfolgend unter Bezugnahme auf Fig. 4 beschrieben.

Bei weiteren bevorzugten Ausführungsformen kann zur Ausbildung der Tasche 102 zusätzlich zu den Schichten 120, 130 auch Material der Trägerplatte 110 zumindest bereichsweise entfernt werden, vgl. die Seitenansicht der Schaltungsträgerplatte 100c aus Figur 4 und den optionalen Schritt 206 aus Fig. 9B. Vorliegend weist die Tasche eine gestufte Geometrie mit zwei Raumbereichen 102a, 102b auf, wobei in dem Bereich 102a das Material der Schichten 120, 130 so weit um den Aufnahmebereich für den Einsatz 300 herum (entlang einer Horizontalen in Fig. 4 und senkrecht zur Zeichenebene der Fig. 4) entfernt worden ist, dass kein Kontakt zwischen den Seitenrändern SR der Schichten 120, 130 und dem Einsatz 300 erfolgt. Dadurch wird insbesondere auch eine ggf. unerwünschte elektrische Kontaktierung zwischen der Funktionsschicht 130 und ggf. vorhandenen elektrisch leitfähigen Strukturen des Einsatzes 300 vermieden. In dem zweiten Bereich 102b ist das Material der Trägerplatte 110 gegenüber dem ersten Bereich 102a in geringerem Maße entfernt worden, insbesondere so, dass ein Einpressen 210 (Fig. 9A) unter Aufbringung einer nichtverschwindenden Einpresskraft K (Fig. 1A) auszuführen ist, die insbesondere größer ist als eine Gewichtskraft des Einsatzes 300. Dadurch wird ein sicheres Einpressen und danach eine sichere Halterung des eingepressten Einsatzes 300 in der Trägerplatte 110 bewirkt.

Figur 5 zeigt schematisch eine Draufsicht auf eine Schaltungsträgerplatte 100d während der Herstellung gemäß weiteren bevorzugten Ausführungsformen. Es ist ein rechteckringförmiger Bereich 130a' der Oberfläche 130a der metallischen Funktionsschicht 130 ersichtlich, in dem zumindest das metallische Material der Funktionsschicht 130 (und optional ggf. Material einer dielektrischen Schicht 120 und weiter optional ggf. Material der Trägerplatte) entfernt worden ist, insbesondere um eine Kontaktierung des Einsatzes 300 zu verhindern.

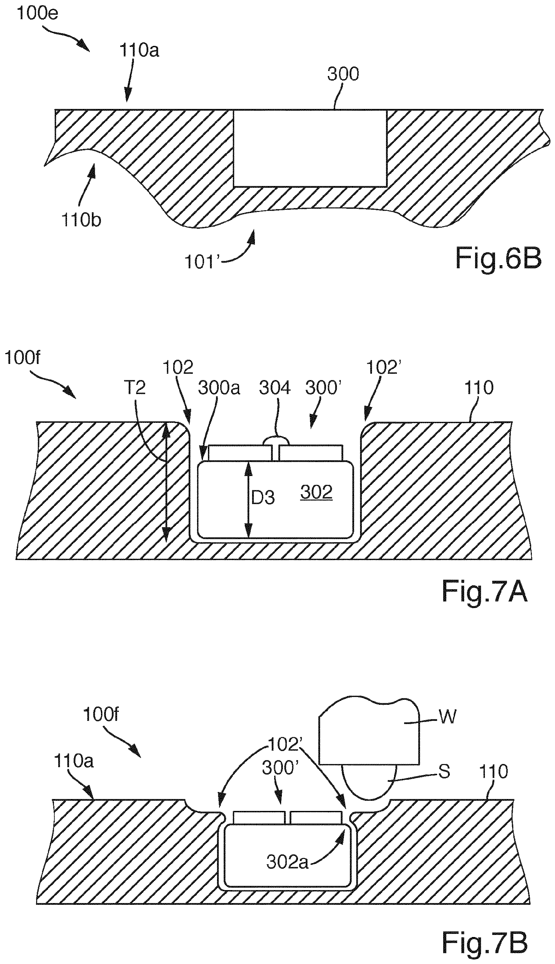

Bei weiteren bevorzugten Ausführungsformen, vgl. die Seitenansicht der Schaltungsträgerplatte 100e aus Figur 6A, 6B, ist vorgesehen, dass der Einsatz 300 vollständig, insbesondere oberflächenbündig, in die metallische Trägerplatte 110` eingepresst wird. Dies ist bei weiteren bevorzugte Ausführungsformen besonders effizient ausführbar, wenn die metallische Trägerplatte 110' profiliert ist, wobei das Einpressen des Einsatzes 300 in einem Oberflächenbereich OB2 der Trägerplatte 110` erfolgt, in dem eine lokale Dicke D2b der Trägerplatte 110' geringer ist als eine maximale Dicke D2a der Trägerplatte 110', vgl. Fig. 6A.

Beispielsweise ändert sich die Dicke der Trägerplatte 110` wie in Fig. 6A gezeigt z.B. entlang der in Fig. 6A horizontalen Breitenkoordinate der Trägerplatte 110', z.B. sinusförmig, während die Dicke der Trägerplatte 110' entlang der zu der Breitenkoordinate orthogonalen Längenkoordinate (senkrecht zur Zeichenebene der Fig. 6A) zumindest in etwa konstant bleibt. Eine Trägerplatte 110' mit einem derartigen Profil kann bei weiteren bevorzugten Ausführungsformen beispielhaft mittels Strangpressen erhalten werden.

Bevorzugt wird der Einsatz 300 demnach in einem Bereich eines "Wellentals" WT (minimale Dicke D2b) der i.w. sinusförmigen Oberfläche 110b der Trägerplatte 110` eingepresst, wodurch weniger Material der Trägerplatte 110` zu verdrängen (und plastisch zu verformen) ist, als bei einem Einbringen des Einsatzes 300 in einen Bereich der Trägerplatte 110' mit einem "Wellenberg" WB (maximale Dicke D2a) .

Figur 6B zeigt einen Zustand, in dem der Einsatz 300 i.w. vollständig, also oberflächenbündig (bezogen auf die erste Oberfläche 110a), in die Trägerplatte 110' eingepresst ist. Eine plastische Verformung der Trägerplatte 110' im Bereich ihrer zweiten Oberfläche 110b ist mit dem Bezugszeichen 101' bezeichnet.

Bei weiteren bevorzugten Ausführungsformen ist eine Geometrie des Einsatzes 300 abgestimmt auf die Profilierung der Trägerplatte 110' und/oder umgekehrt. Beispielsweise kann für einen Einsatz 300 vorgebbarer Breite (betrachtet entlang einer Horizontalen der Fig. 6A) eine Trägerplatte 110' mit einer Periodizität der z.B. sinusförmigen Profilierung derart ausgewählt werden, dass ein Wellental WT der sinusförmigen Profilierung hinsichtlich seiner Breite i.w. der Breite des einzupressenden Einsatzes 300 entspricht, z.B. eine Wellenlänge der sinusförmigen Profilierung der doppelten Breite des Einsatzes 300 entspricht.

Bei weiteren bevorzugten Ausführungsformen kann auch die profilierte Trägerplatte 110' gemäß Fig. 6A, 6B eine oder mehrere Schichten 120, 130, vgl. Fig. 3, aufweisen (nicht gezeigt).

Figur 7A zeigt schematisch eine Seitenansicht einer Schaltungsträgerplatte 100f während der Herstellung gemäß einer weiteren Ausführungsform der Erfindung in teilweisem Querschnitt in einem ersten Zustand, in dem eine Tasche 102 der Tiefe T2 in der Trägerplatte 110 angefertigt (z.B. durch Entfernen von Material der Trägerplatte 110 gemäß Schritt 206 aus Fig. 9B, insbesondere mittels Fräsen) und ein Einsatz 300` in die Tasche 102 eingelegt ist. Vorliegend weist der Einsatz 300` einen Grundkörper 302 aus einem Keramikmaterial auf, sowie eine auf seiner Oberfläche 300a angeordnete metallische Funktionsschicht mit einer Strukturierung, vorliegend z.B. aufweisend zwei Kontaktierungsbereiche 304 zur elektrischen Kontaktierung eines Bauelements. Die Dicke D3 des Grundkörpers 302 ist bevorzugt kleiner als die Tiefe T2.

Bei weiteren bevorzugten Ausführungsformen kann der Einsatz 300' auch eine Bestückung (nicht gezeigt) aufweisen, z.B. ein oder mehrere Baugruppen, insbesondere LED-Baugruppen bzw. LED-Chips und/oder andere Halbleiterbauelemente und/oder sonstige elektronische bzw. elektrische bzw. elektromechanische Bauelemente. Das nachstehend näher Beschrieben Verfahren ermöglicht ein zuverlässiges und schonendes Einbringen auch solcher bereits bestückter Einsätze in das Trägerelement 110.

Figur 7B zeigt schematisch eine Seitenansicht der Schaltungsträgerplatte 100f gemäß Fig. 7A in teilweisem Querschnitt in einem zweiten Zustand, in dem der Einsatz 300` wenigstens formschlüssig in der Tasche 102 (Fig. 7A) gehalten ist. Dies kann, ausgehend von dem ersten Zustand gemäß Figur 7A, bei der Herstellung gemäß der weiteren Ausführungsform der Erfindung durch ein plastisches Verformen wenigstens eines Randbereichs 102' der Tasche 102 mittels eines Werkzeugs W (Fig. 7B) erzielt werden. Beispielsweise wird mittels des Werkzeugs W eine in Fig. 7B vertikal nach unten gerichtete Kraft auf die Oberfläche 110a des Trägerelements 110 ausgeübt, insbesondere in dem Randbereich 102', wodurch sich das Material des Trägerelements 110 in dem Randbereich 102' wie abgebildet plastisch verformt und radial nach innen, über einen Rand 302a des Grundkörpers 302 des Einsatzes 300` hinweg bewegt und - auch bei Abwesenheit der genannten Kraft - in dieser Lage verbleibt.

Bei weiteren bevorzugten Ausführungsformen kann das Werkzeug W über einen i.w. konvex, insbesondere etwa halbkugelförmig, ausgebildeten Stempel S verfügen, um das Material des Trägerelements 110 wie beschrieben zu verformen.

Bei dieser Ausführungsform der Erfindung wird demnach der zuvor in die Tasche eingelegte bzw. eingepresste Einsatz 300', insbesondere der Grundkörper 302 des Einsatzes 300', formschlüssig durch den wenigstens einen plastisch verformten Randbereich 102` in der Tasche gehalten. Bei weiteren bevorzugten Ausführungsformen kann zusätzlich noch

ein Kraftschluss im Bereich der Seitenwände des Einsatzes 300' mit dem umgebenden Material der Trägerplatte 110 gegeben sein. Ein Kraftschluss zwischen dem Einsatz und der Trägerplatte kann bei weiteren bevorzugten

Ausführungsformen beispielsweise dadurch erzielt werden, dass der Einsatz geringfügig größer ist als eine ihn aufnehmende Öffnung der Trägerplatte, bezogen auf wenigstens eine Größenausdehnung des Einsatzes, die in einer mit der Trägerplatte korrespondierenden Ebene liegt.

Bei weiteren bevorzugten Ausführungsformen ist vorgesehen, dass die Tasche eine mehrere Kanten K1, K2, K3, K4 (Fig. 5) aufweisende polygonale (z.B. zumindest i.w. rechteckförmige) Öffnung im Bereich der Oberfläche 110a der Trägerplatte 110 aufweist, wobei das plastische Verformen des wenigstens eines Randbereichs 102' (Fig. 7B) der Tasche ein plastisches Verformen von mehreren Randbereichen der Tasche aufweist, wobei die mehreren Randbereiche wenigstens zwei bevorzugt nicht nebeneinander liegenden Kanten K1, K3 (Fig. 5) der polygonalen Öffnung entsprechen (z.B. einander gegenüberliegenden Kanten der zumindest i.w. rechteckförmigen Öffnung). Dadurch ist eine besonders sichere Fixierung des Einsatzes 300' (Fig. 7B) in der Trägerplatte 110 ermöglicht.

Figur 9C zeigt ein vereinfachtes Flussdiagramm gemäß der weiteren Ausführungsform der Erfindung. In Schritt 210a wird der Einsatz 300' in die Tasche 102 eingelegt, vgl. den Zustand gemäß Fig. 7A, und in Schritt 210b aus Fig. 9C wird der wenigstens eine Randbereich 102' der Tasche 102 plastisch verformt, um wenigstens den genannten Formschluss zu erzielen. Alternativ oder ergänzend zu dem Einlegen 210a, das z.B. i.w. kräftefrei bzw. schwerkraftunterstützt erfolgen kann, kann Schritt 210a auch ein Einpressen des Einsatzes 300` aufweisen, sodass der Einsatz 300` nach dem Einpressen 210a bereits kraftschlüssig in der Tasche 102 gehalten ist. Bei weiteren bevorzugten Ausführungsformen kann dann optional der Schritt 210b des plastischen Verformens des Randbereichs 102' erfolgen, um (zusätzlich) den genannten Formschluss im Randbereich 302a herzustellen. Figur 8 zeigt schematisch eine perspektivische Ansicht eines Einsatzes 300" für eine Schaltungsträgerplatte hergestellt gemäß weiteren bevorzugten Ausführungsformen. Beispielsweise kann der Einsatz 300, 300` die in Fig. 8 abgebildete Konfiguration aufweisen.

Der Einsatz 300" weist einen Grundkörper 302 auf, der aus einem Keramikmaterial besteht, z.B. Aluminiumnitrid (AlN)-Keramik. Optional weist der Einsatz 300" wenigstens eine metallische Funktionsschicht 306, 312 auf, z.B. eine strukturierbare und/oder zumindest bereichsweise bereits strukturierte oder eine unstrukturierte Kupferschicht. Weiter optional kann zwischen dem Grundkörper 302 und der wenigstens einen metallischen Funktionsschicht 306, 312 jeweils eine Zwischenschicht ("Treatment"), z.B. eine Titan enthaltende Zwischenschicht 308, 310, vorgesehen sein, die z.B. die Haftung der metallischen Funktionsschicht 306, 312 an dem Keramikmaterial des Grundkörpers 302 verbessert. Figur 10 zeigt schematisch eine perspektivische Ansicht

einer Schaltungsträgerplatte 100g hergestellt gemäß weiteren bevorzugten Ausführungsformen. Die Schaltungsträgerplatte 100g weist eine metallische Trägerplatte 110" auf, die vorliegend bereichsweise eben ausgebildet ist, wodurch eine Plattenebene definiert wird. Weiter weist die metallische Trägerplatte 110" mehrere bezüglich der Plattenebene (z.B. um einen Winkel von etwa 90°, in Fig. 10 nach oben) abgebogene Randbereiche RB auf, wobei die metallische Trägerplatte 110" z.B. als Kühlkörper nutzbar ist. Ein keramisches Material aufweisender Einsatz 300‴ wird unter Anwendung des Verfahrens gemäß bevorzugten

Ausführungsformen in Fig. 10 vertikal nach oben in die Trägerplatte 110" eingepresst, u.a. um eine thermisch leitfähige Verbindung zwischen dem Einsatz 300‴ und der Trägerplatte 110" herzustellen, die insbesondere zumindest teilweise auch einen Wärmetransport von dem Einsatz 300‴, insbesondere dessen Seitenwänden SW entlang der Plattenebene bzw. einer virtuellen Ebene, die parallel zur Plattenebene ist, in die Trägerplatte 110" ermöglicht, wodurch eine besonders effiziente Entwärmung des Einsatzes 300‴ gegeben ist. Gleichzeitig ist der Einsatz 300‴ durch das Einpressen sicher kraft- und/oder formschlüssig in der Trägerplatte 110" gehalten. Optional kann der Einsatz 300‴ auf einer in Fig. 10 vertikal nach unten weisenden Oberfläche 300a eine strukturierbare und/oder zumindest bereits teilweise strukturierte metallische Funktionsschicht aufweisen. Vorliegend sind auf der Oberfläche 300a z.B. zwei Anschlusspads aus Kupfer angeordnet, z.B. zur Aufnahme eines zu entwärmenden Bauelements, z.B. eines optoelektronischen Bauelements, insbesondere einer Leuchtdiode.

Bei weiteren bevorzugten Ausführungsformen ist eine weitere Schaltungsträgerplatte 400 vorgesehen, die z.B. einen Kern aus einem Faserverbundwerkstoff (z.B. FR4-Material) aufweisen kann. Optional kann die weitere Schaltungsträgerplatte 400 über eine Anschlussbuchse 402 zur Kontaktierung weiterer Komponente z.B. mittels eines Kabels (nicht gezeigt) verfügen. Weiter optional kann die weitere Schaltungsträgerplatte 400 eine Bohrung 404 und die Trägerplatte 110'' eine nicht abgebildete Gewindebohrung aufweisen, in die eine Schraube 405 einschraubbar ist, um die weitere Schaltungsträgerplatte 400 mechanisch lösbar an der Trägerplatte 110" zu befestigen. Eine elektrische Kontaktierung zwischen der weiteren Schaltungsträgerplatte 400 und den beiden Anschlusspads (nicht gezeigt) des Einsatzes 300‴ kann beispielsweise durch Vorsehung von elektrischen Anschlussbereichen ("Kantengalvanik") 406 in einem der Anschlussbuchse 402 gegenüberliegenden axialen Endbereich der weiteren Schaltungsträgerplatte 400 und durch Herstellen von Lötverbindungen zwischen der Kantengalvanik 406 und den Anschlusspads, insbesondere mittels Laserlöten, erfolgen. Details zu der Kantengalvanik 406 sind in der DE 10 2014 225 077 A1 der Anmelderin beschrieben.

Bei weiteren bevorzugten Ausführungsformen ist vorgesehen, dass die metallische Trägerplatte 110, 110', 110", 1100 ein Nichteisenmetall, insbesondere Aluminium, aufweist.

Bei weiteren bevorzugten Ausführungsformen weist die Trägerplatte 110, 110', 110", 1100 z.B. den folgenden Werkstoff auf, oder ein vergleichbares, insbesondere ebenfalls vergleichsweise gut verformbares, Material : Al99,5 (3.0255 (DIN 1725-1)) Europäische Norm (EN) AW 1050.

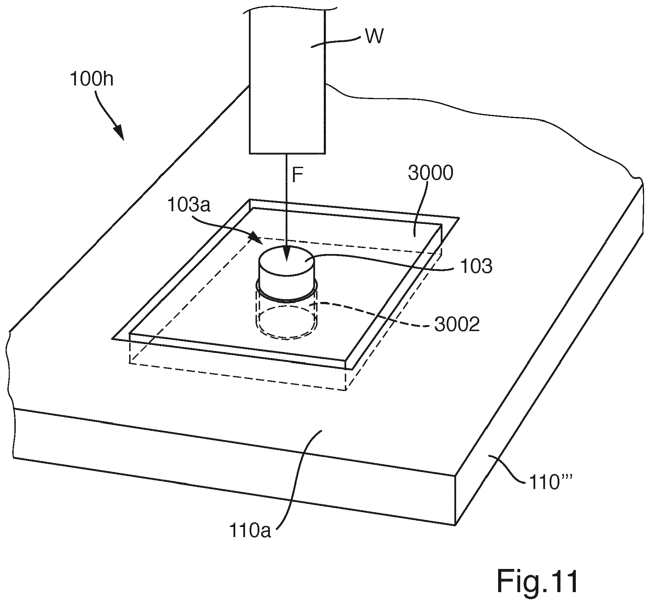

Fig. 11 zeigt schematisch eine perspektivische Ansicht einer Schaltungsträgerplatte 100h. Ein Einsatz 3000 weist wenigstens eine Öffnung 3002, z.B. eine Bohrung 3002, auf, mittels der er auf wenigstens einem Führungselement 103, insbesondere einem Zapfen 103, der Trägerplatte 110‴ der Schaltungsträgerplatte 100h führbar ist. Bevorzugt erstreckt sich der Zapfen 103 zumindest in etwa senkrecht zu einer Oberfläche 110a der Trägerplatte 110‴, wodurch der Einsatz 3000 präzise auf der Trägerplatte 110‴ angeordnet, insbesondere positioniert, werden kann. Bevorzugt kann die Trägerplatte 110‴ eine Öffnung 102, insbesondere Tasche 102, aufweisen, ähnlich der Konfiguration nach Fig. 2. Durch ein, insbesondere plastisches, Verformen eines in Fig. 11 oberen Bereichs 103a des Zapfens 103 kann vorteilhaft nach dem Positionieren des Einsatzes 3000 auf dem Zapfen 103 wenigstens ein Formschluss zwischen dem Zapfen 103, insbesondere seinem oberen Bereich 103a, und dem in die Tasche 102 eingelegten Einsatz 3000 geschaffen werden, vergleichbar zu einer Nietverbindung. Das Verformen des Zapfens 103 kann beispielsweise mittels eines Werkzeugs W erfolgen, vgl. auch den Pfeil F in Fig. 11.

## Patentansprüche

1. Verfahren zum Herstellen einer Schaltungsträgerplatte (100;
100a; 100b; 100c; 100d; 100e; 100f; 100g), aufweisend die folgenden Schritte: Bereitstellen (200) einer metallischen Trägerplatte (110; 110'; 110"), Einpressen (210) eines wenigstens ein Keramikmaterial aufweisenden Einsatzes (300; 300'; 300"; 300‴) in die metallische Trägerplatte (110; 110'; 110"), wobei die metallische Trägerplatte (110; 110'; 110") während des Einpressens (210) zumindest bereichsweise plastisch verformt wird, wobei Material der Trägerplatte zumindest bereichsweise durch das Material des Einsatzes verdrängt und der Einsatz wenigstens mit seiner Unterseite in das Material der Trägerplatte eingebettet wird.

2. Verfahren nach Anspruch 1, wobei der Einsatz (300; 300'; 300''; 300‴) vollständig, insbesondere oberflächenbündig, in die metallische Trägerplatte (110; 110'; 110") eingepresst wird.

3. Verfahren nach wenigstens einem der vorstehenden Ansprüche, wobei auf wenigstens einer Oberfläche (110a) der metallischen Trägerplatte (110; 110'; 110") zumindest bereichsweise eine dielektrische Schicht (120) angeordnet ist, und wobei auf einer ersten Oberfläche (120a) der dielektrischen Schicht (120) zumindest bereichsweise eine metallische Funktionsschicht (130) angeordnet ist, wobei das Verfahren weiter aufweist: zumindest bereichsweises Entfernen (205) wenigstens einer der beiden Schichten (120, 130), insbesondere in einem Oberflächenbereich (OB1) der Trägerplatte (110; 110'; 110"), in dem der Einsatz (300; 300'; 300''; 300‴) eingepresst werden soll.

4. Verfahren nach wenigstens einem der vorstehenden Ansprüche, wobei die metallische Trägerplatte (110; 110'; 110'') profiliert ist, und wobei das Einpressen (210) des Einsatzes (300; 300'; 300''; 300‴) in einem Oberflächenbereich (OB2) der Trägerplatte (110; 110'; 110") erfolgt, in dem eine lokale Dicke (D2b) der Trägerplatte (110; 110'; 110") geringer ist als eine maximale Dicke (D2a) der Trägerplatte (110; 110'; 110").

5. Verfahren zum Herstellen einer Schaltungsträgerplatte (100f), aufweisend die folgenden Schritte: Bereitstellen (200) einer metallischen Trägerplatte (110), zumindest bereichsweises Entfernen (206) von Material der metallischen Trägerplatte (110), insbesondere in einem Oberflächenbereich (OB1) der Trägerplatte (110), zum Anfertigen einer Tasche (102) in der Trägerplatte (110) zur Aufnahme eines Einsatzes (300'), Einlegen (210a) und/oder Einpressen eines wenigstens ein Keramikmaterial aufweisenden Einsatzes (300') in die Tasche (102), und, nach dem Einlegen (210a) und/oder Einpressen, plastisches Verformen (210b) wenigstens eines Randbereichs (102') der Tasche (102) so, dass der Einsatz (300'), insbesondere der Grundkörper (302) des Einsatzes (300'), formschlüssig durch wenigstens einen plastisch verformten Randbereich (102') in der Tasche (102) gehalten ist.

6. Verfahren nach Anspruch 5, wobei eine Tiefe (T2) der Tasche (102) gleich oder größer einer Dicke (D3) des Einsatzes (300') ist, insbesondere gleich oder größer einer Dicke (D3) eines Grundkörpers (302) des Einsatzes (300').

7. Verfahren nach Anspruch 6, wobei die Tasche (102) eine mehrere Kanten (K1, K2, K3, K4) aufweisende polygonale Öffnung im Bereich der Oberfläche (110a) der Trägerplatte (110) aufweist, und wobei das plastische Verformen (210b) des wenigstens eines Randbereichs (102') der Tasche (102) ein plastisches Verformen von mehreren Randbereichen der Tasche (102) aufweist, wobei die mehreren Randbereiche wenigstens zwei bevorzugt nicht nebeneinander liegenden Kanten (K1, K3) der polygonalen Öffnung entsprechen.

8. Schaltungsträgerplatte (100; 100a; 100b; 100c; 100d; 100e; 100f; 100g), erhältlich durch ein Verfahren nach wenigstens einem der vorstehenden Ansprüche.

9. Schaltungsträgerplatte (100; 100a; 100b; 100c; 100d; 100e; 100f; 100g) nach Anspruch 8, wobei der Einsatz (300; 300'; 300''; 300‴) kraftschlüssig und/oder formschlüssig in der Trägerplatte (110; 110'; 110'') gehalten ist.

10. Schaltungsträgerplatte (100; 100a; 100b; 100c; 100d; 100e; 100f; 100g) nach wenigstens einem der Ansprüche 8 bis 9, wobei der Einsatz (300; 300'; 300"; 300‴) zumindest teilweise in die metallische Trägerplatte (110; 110'; 110") eingepresst ist, wobei insbesondere der Einsatz (300; 300'; 300''; 300‴) vollständig, insbesondere oberflächenbündig, in die metallische Trägerplatte (110; 110'; 110") eingepresst ist.

11. Schaltungsträgerplatte (100; 100a; 100b; 100c; 100d; 100e; 100f; 100g) nach wenigstens einem der Ansprüche 8 bis 10, wobei die metallische Trägerplatte (110; 110'; 110") profiliert ist, und wobei der Einsatz (300; 300'; 300"; 300‴) in einem Oberflächenbereich (OB2) der Trägerplatte (110; 110'; 110") eingepresst ist, in dem eine lokale Dicke der Trägerplatte (110; 110'; 110") geringer ist als eine maximale Dicke der Trägerplatte (110; 110'; 110").

12. Schaltungsträgerplatte (100; 100a; 100b; 100c; 100d; 100e; 100f; 100g) nach wenigstens einem der Ansprüche 8 bis 11, wobei die metallische Trägerplatte (110; 110'; 110") ein Nichteisenmetall, insbesondere Aluminium, aufweist.

## Claims

1. Method for producing a circuit carrier plate (100;
100a; 100b; 100c; 100d; 100e; 100f; 100g), comprising the following steps: providing (200) a metal carrier plate (110; 110'; 110''), pressing (210) an insert (300; 300'; 300''; 300''') having at least one ceramic material into the metal carrier plate (110; 110'; 110"), wherein the metal carrier plate (110; 110'; 110") is plastically deformed at least in some regions during the pressing in (210), wherein material of the carrier plate is displaced at least in some regions by the material of the insert and the insert is embedded at least with its bottom into the material of the carrier plate.

2. Method according to claim 1, wherein the insert (300; 300'; 300''; 300‴) pressed into the metal carrier plate (110; 110'; 110'') completely, in particular in a surface-flush manner.

3. Method according to at least one of the preceding claims, wherein a dielectric layer (120) is arranged at least in some regions on at least one surface (110a) of the metal carrier plate (110; 110'; 110''), and wherein a metal functional layer (130) is arranged at least in some regions on a first surface (120a) of the dielectric layer (120), wherein the method further comprises: removing (205) at least one of the two layers (120, 130) at least in some regions, in particular in a surface region (OB1) of the carrier plate (110; 110'; 110''), into which the insert (300; 300'; 300"; 300‴ is to be pressed.

4. Method according to at least one of the preceding claims, wherein the metal carrier plate (110; 110'; 110") is profiled, and wherein the pressing in (210) of the insert (300; 300'; 300"; 300‴) takes place in a surface region (OB2) of the carrier plate (110; 110'; 110''), in which a local thickness (D2b) of the carrier plate (110; 110'; 110'') is lower than a maximum thickness (D2a) of the carrier plate (110; 110'; 110'').

5. Method for producing a circuit carrier plate (100f), comprising the following steps: providing (200) a metal carrier plate (110), removing (206) material from the metal carrier plate (110) at least in some regions, in particular in a surface region (OB1) of the carrier plate (110), in order to produce a pocket (102) in the carrier plate (110) for receiving an insert (300'), inserting (210a) and/or pressing an insert (300') having at least one ceramic material into the pocket (102), and, after the insertion (210a) and/or pressing in step, plastically deforming (210b) at least one edge region (102') of the pocket (102) such that the insert (300'), in particular the main body (302) of the insert (300'), is form-fittingly held in the pocket (102) by at least one plastically deformed edge region (102').

6. Method according to claim 5, wherein a depth (T2) of the pocket (102) is equal to or greater than a thickness (D3) of the insert (300'), in particular equal to or greater than a thickness (D3) of a main body (302) of the insert (300').

7. Method according to claim 6, wherein the pocket (102) has a polygonal opening, having a plurality of edges (K1, K2, K3, K4), in the region of the surface (110a) of the carrier plate (110), and wherein the plastic deformation (210b) of the at least one edge region (102') of the pocket (102) has a plastic deformation of a plurality of edge regions of the pocket (102), wherein the plurality of edge regions correspond to at least two edges (K1, K3) of the polygonal opening, which are preferably not adjacent to one another.

8. Circuit carrier plate (100; 100a; 100b; 100c; 100d; 100e; 100f; 100g), which can be obtained by a method according to at least one of the preceding claims.

9. Circuit carrier plate (100; 100a; 100b; 100c; 100d; 100e; 100f; 100g) according to claim 8, wherein the insert (300; 300'; 300''; 300‴) is frictionally and/or form-fittingly held in the carrier plate (110; 110'; 110'').

10. Circuit carrier plate (100; 100a; 100b; 100c; 100d; 100e; 100f; 100g) according to at least one of claims 8 to 9, wherein the insert (300; 300'; 300"; 300‴) is at least partially pressed into the metal carrier plate (110; 110'; 110''), wherein in particular the insert (300; 300'; 300''; 300‴) is pressed into the metal carrier plate (110; 110'; 110'') completely, in particular in a surface-flush manner.

11. Circuit carrier plate (100; 100a; 100b; 100c; 100d; 100e; 100f; 100g) according to at least one of claims 8 to 10, wherein the metal carrier plate (110; 110'; 110") is profiled, and wherein the insert (300; 300'; 300''; 300‴) is pressed into a surface region (OB2) of the carrier plate (110; 110'; 110''), in which a local thickness of the carrier plate (110; 110'; 110'') is lower than a maximum thickness of the carrier plate (110; 110'; 110'').

12. Circuit carrier plate (100; 100a; 100b; 100c; 100d; 100e; 100f; 100g) according to at least one of claims 8 to 11, wherein the metal carrier plate (110; 110'; 110") has a non-ferrous metal, in particular aluminum.

## Revendications

1. Procédé de fabrication d'une plaque de support de circuit (100; 100a; 100b; 100c; 100d; 100e; 100f; 100g), comprenant les étapes ci-dessous consistant à: fournir (200) une plaque de support métallique (110; 110'; 110''), encastrer (210) un insert (300; 300'; 300"; 300''') comprenant au moins un matériau céramique dans la plaque de support métallique (110; 110'; 110''), la plaque de support métallique (110; 110'; 110'') étant déformée de manière plastique au moins par endroits pendant l'étape d'encastrage (210), le matériau de la plaque de support étant déplacé au moins par endroits par le matériau de l'insert et au moins la face inférieure de l'insert étant noyée dans le matériau de la plaque de support.

2. Procédé selon la revendication 1, l'insert (300; 300'; 300"; 300''') étant encastré complètement, en particulier au ras de la surface, dans la plaque de support métallique (110; 110'; 110'').

3. Procédé selon au moins l'une quelconque des revendications précédentes, une couche diélectrique (120) étant agencée au moins par endroits sur au moins une surface (110a) de la plaque de support métallique (110; 110'; 110''), et une couche fonctionnelle métallique (130) étant agencée au moins par endroits sur une première surface (120a) de la couche diélectrique (120), le procédé comprenant en outre l'étape consistant à: enlever (205) au moins par endroits au moins l'une des deux couches (120, 130), en particulier dans une région de surface (OB1), au sein de laquelle l'insert (300; 300'; 300"; 300''') doit être encastré, de la plaque de support (110; 110'; 110'').

4. Procédé selon au moins l'une quelconque des revendications précédentes, la plaque de support métallique (110; 110'; 110'') étant profilée, et l'étape d'encastrage (210) de l'insert (300; 300'; 300"; 300''') intervenant dans une région de surface (OB2) de la plaque de support (110; 110'; 110'') au sein de laquelle une épaisseur locale (D2b) de la plaque de support (110; 110'; 110") est inférieure à une épaisseur maximale (D2a) de la plaque de support (110; 110'; 110'').

5. Procédé de fabrication d'une plaque de support de circuit (100f), comprenant les étapes ci-dessous consistant à: fournir (200) une plaque de support métallique (110), enlever (206) au moins par endroits le matériau de la plaque de support métallique (110), en particulier dans une région de surface (OB1) de la plaque de support (110), afin de réaliser dans la plaque de support (110) une poche (102) permettant d'accueillir un insert (300'), insérer (210a) et/ou encastrer un insert (300') comprenant au moins un matériau céramique dans la poche (102), et, après l'étape d'insertion (210a) et/ou d'encastrage, déformer de manière plastique (210b) au moins une région de bord (102') de la poche (102) de sorte que l'insert (300'), en particulier le corps de base (302) de l'insert (300') soit retenu dans la poche (102) par complémentarité de forme grâce à au moins une région de bord (102') déformée de manière plastique.

6. Procédé selon la revendication 5, une profondeur (T2) de la poche (102) étant supérieure ou égale à une épaisseur (D3) de l'insert (300'), en particulier supérieure ou égale à une épaisseur (D3) d'un corps de base (302) de l'insert (300').

7. Procédé selon la revendication 6, la poche (102) comprenant une ouverture polygonale comportant plusieurs bords (K1, K2, K3, K4) dans la région de la surface (110a) de la plaque de support (110), et la déformation plastique (210b) d'au moins une région de bord (102') de la poche (102) comprenant une déformation plastique de plusieurs régions de bord de la poche (102), lesdites plusieurs régions de bord correspondant à au moins deux bords (K1, K3), de manière préférée non adjacents, de l'ouverture polygonale.

8. Plaque de support de circuit (100; 100a; 100b; 100c; 100d; 100e; 100f; 100g), pouvant être obtenue grâce à un procédé selon au moins l'une quelconque des revendications précédentes.

9. Plaque de support de circuit (100; 100a; 100b; 100c; 100d; 100e; 100f; 100g) selon la revendication 8, l'insert (300; 300'; 300"; 300‴) étant retenu par complémentarité de force et/ou par complémentarité de forme dans la plaque de support (110; 110'; 110'').

10. Plaque de support de circuit (100; 100a; 100b; 100c; 100d; 100e; 100f; 100g) selon au moins l'une quelconque des revendications 8 à 9, l'insert (300; 300'; 300"; 300''') étant encastré au moins partiellement dans la plaque de support métallique (110; 110'; 110''), en particulier l'insert (300; 300'; 300"; 300''') étant encastré complètement, en particulier au ras de la surface, dans la plaque de support métallique (110; 110'; 110'').

11. Plaque de support de circuit (100; 100a; 100b; 100c; 100d; 100e; 100f; 100g) selon au moins l'une quelconque des revendications 8 à 10, la plaque de support métallique (110; 110'; 110'') étant profilée, et l'insert (300; 300'; 300"; 300‴) étant encastré dans une région de surface (OB2) de la plaque de support (110; 110'; 110'') au sein de laquelle une épaisseur locale de la plaque de support (110; 110'; 110'') est inférieure à une épaisseur maximale de la plaque de support (110; 110'; 110'').

12. Plaque de support de circuit (100; 100a; 100b; 100c; 100d; 100e; 100f; 100g) selon au moins l'une quelconque des revendications 8 à 11, la plaque de support métallique (110; 110'; 110") comprenant un métal non ferreux, en particulier de l'aluminium.
